# EUROPEAN PATENT APPLICATION

(11) **EP 1 107 331 A2**
(43) Date of publication of application: **13.06.2001**
(21) Application number: 00126886.1
(22) Date of filing: 07.12.2000
(51) Int. Cl.: H01L 51/20, C09K 11/06, H01L 51/40

(54) **Material for organic electroluminescence device and process for producing the same**

(30) Priority: 09.12.1999 JP 35050399; 17.07.2000 JP 2000215991
(71) Applicant: Daicel Chemical Industries, Ltd., Sakai-shi, Osaka 590-8501 (JP)
(72) Inventor: Kitaguchi, Toru, Yokohama-shi, Kanagawa 244-0802 (JP); Kambara, Shigeki, Himeji-shi, Hyogo 671-1262 (JP); Fukumara, Hiroshi, Sendai-shi, Miyagi 980-0861 (JP)
(74) Representative: Grünecker, Kinkeldey, Stockmair & Schwanhäusser Anwaltssozietät

(57) **Abstract**

An organic electroluminescence material is produced by bringing a source (1) containing at least an emission center-forming compound absorptive of a laser beam and defined in the predetermined pattern into contact with targets (2a, 2b) which is transmittable of the laser beam and has at least one function selected from an electron-transporting function and a hole-transporting function, and irradiating with the laser beam from the target (2) side to implant the emission center-forming compound (3) contained in the source (1) into the target (2a). The organic electroluminescence device thus obtained has emission centers in the area corresponding to the pattern of the source. The source may be constituted solely of the emission center-forming compound. The present invention provides an organic EL material susceptible of fine patterning, a process for producing the same, and an organic EL device using the same.

## Description

### FIELD OF THE INVENTION

The present invention relates to a process for producing a material for organic electroluminescence device by implanting or injecting an emission center-forming compound into the predetermined area through molecular implantation with laser, a material for organic electroluminescence device obtained by this process, and to an organic electroluminescence device (elements) produced with this organic electroluminescence material.

### BACKGROUND OF THE INVENTION

Electroluminescence devices (hereinafter, occasionally referred to simply as EL devices) have generally been classified as inorganic EL devices or organic EL devices according to the materials they are made from. Some inorganic EL devices utilizing inorganic fluorescent molecules are already in practical use, and have been brought into application to the backlight of clocks or the like. Meanwhile, organic EL devices have been desired to be brought into practical use because of their being more excellent in brightness or luminance, efficiency, and high-speed responsivity than inorganic ones.

Electroluminescence devices are constituted of a compound or compounds having an electron-transporting function, a hole-transporting function, and an emission center-forming function. As for their structures, there have been reported devices of the single-layer type having a single layer provided with all the functions mentioned above, and those of the multilayer-type composed of layers having different functions. The principle of light emission is considered to be based on the phenomenon that electrons and holes injected from a pair of electrodes recombine within a light-emitting layer to form excitons, exciting the molecules of a light emissive material for the light-emitting layer.

As a compound constituting each layer, a low-molecular weight compound of high light-emission efficiency, a macromolecular compound having a high physical strength, or the like is employed. However, when a low-molecular weight compound is used, a film is formed by means of a vapor deposition technique which is inferior in productivity, while a macromolecular compound is formed into a film by coating or applying a solution and thus capable of being formed into films of larger sizes.

Japanese Patent Application Laid-Open No. 96959/1996 (JP-A-8-96959) and Japanese Patent Application Laid-Open No. 63770/1997 (JP-A-9-63770) disclose organic EL devices comprising a single light-emitting layer made of a polymer binder having both electron-transporting function and hole-transporting function, within which varieties of fluorescent dyes (or colorants, pigments) are dispersed. These organic EL devises are reported to present, as a whole, white light due to the light emission of each light-emitting compound independent of one another. Moreover, as compared with organic EL devices of the multilayer-type, those of the single-layer type are hardly deteriorated in light-emission intensity.

Fine patterning, particularly multicolor patterning (full-coloration) of these organic EL devices is difficult because, in their fabrication, a film is formed by means of a solution coating technique in which a solution of a polymer binder and a fluorescent dye(s) dispersed in a specific solvent is applied onto a substrate.

As multicolor patterning methods, a color filer method, a color-converting method, the ink-jet method by T.R.Hebner (Appl. Phys. Lett. 72,5 (1998), p.519), the photobleaching method by Kido, et al, and others have been reported.

The color filter method or color-converting method has the advantage of not requiring the patterning of a light-emitting layer, but suffers deterioration in conversion efficiency caused by the use of a filter. In the ink-jet method, since a pattern formed by ink-jet printing shows a center-raised, i.e., conical profile and is inferior in smoothness of its surface, it is difficult to provide electrodes thereon uniformely. Moreover, the cross section of the pattern is desired to be rectangular, but that of a pattern by ink-jet printing cannot be formed so and is circular. Further, the dimensions of a pattern largely depends on conditions under which the pattern is dried and the concentration of the solution. In the photobleaching method, only a special emission center-forming compound which loses its fluorescence upon UV oxidation is employable and therefore colors expressable by EL devices are limited.

As was described above, in conventional film-forming methods by solution coating, although it is possible to use a macromolecular compound with a high physical strength, it is difficult to provide fine patterns. In addition to that, also in the above-described patterning methods, compounds that can be used are limited, and films having surface smoothness suitable for organic EL devices cannot be obtained.

As the molecular implantation technique, Japanese Patent Application Laid-Open No. 297457/1994 (JP-A-6-297457) discloses a method comprising a step of, with a functional material or a solid material containing a functional material (A) and a solid material into which a functional component is to be implanted (B) placed such as to face each other, irradiating a laser pulse thereby to implant the functional component into the solid material (B). Japanese Patent Application Laid-Open No. 106006/1996 (JP-A-8-106006) discloses a method comprising the steps of bringing a source film of an organic macromolecular compound within which dyes absorptive of a pulse laser are dispersed into tight contact with a target film of an organic macromolecular compound transmittable of a pulse laser, and irradiating a pulse laser from the target film side at an intensity of or below the ablation threshold value of the source film thereby to implant the dyes into the target film. This literature says that the molecular implantation technique can be utilized in the fabrication of color filters for use in displays or the like.

Moreover, WO 00/13470 discloses a process of producing a material for use in an organic electroluminescence device, in which a source containing an emission center-forming compound absorptive of a laser beam is brought into contact with a target having an electron-transporting function and/or a hole-transporting function and the source is irradiated with a pulsed laser beam at an intensity not higher than the ablation threshold of the source thereby to inject the emission center-forming compound into the target. In this specification, the source is constituted of a binder having film-forming properties or capability and 0.1 to 30 parts by weight of the emission center-forming compound per 100 parts by weight of the binder.

### SUMMARY OF THE INVENTION

Accordingly, an object of the present invention is to provide a material for organic EL device (particularly, an organic EL device-use film) susceptible of minute and fine patterning even when a macromolecular compound is used as an EL device-use material, and a process for producing the same.

Another object of the present invention is to provide a material for organic EL device which is excellent in surface smoothness and has good contactness with electrodes, and an organic EL device using the same.

The inventors of the present invention made intensive and extensive studies to achieve the above objects, and finally found that a molecular implantation technique using a source defined in the predetermined pattern or a source constituted solely of an emission center-forming compound makes it possible to provide a material for organic EL device that can be patterned minutely.

That is, the production process of a material for organic EL device of the present invention comprises the steps of
bringing a source (A) containing at least an emission center-forming compound absorptive of a laser beam and defined in the predetermined pattern into contact with a target (B) which is transmittable of a laser beam and has at least one function selected from an electron-transporting function and a hole-transporting function, and
irradiating the laser beam from the source (A) side or the target (B) side to implant the emission center-forming compound into the target (B). According to the production process, material for organic electroluminescence device having luminescence (emission) centers in the area corresponding to the pattern of the source (A). The source may be a film (e.g., a film comprising an emission center-forming compound) formed on a substrate in the predetermined pattern. The source may be comprised of an emission center-forming compound and a binder. The target may be an organic polymer having at least one function selected from the electron-transporting function and the hole-transporting function (e.g., poly-N-vinylcarbazol), or may comprise a compound having at least one function selected from the electron-transporting function and the hole-transporting function and an organic polymer having film-forming properties.

The organic EL device-use material may be in the form of a film, and the laser beam may be a pulse laser beam (pulsed laser) having a pulse width of 10 ps to 10 µs.

Incidentally, the present invention further includes a process for producing a material for use in an organic electroluminescence device by using a source which is constituted solely of an emission center-forming compound and is not formed in the predetermined pattern.

The present invention also includes a material for organic EL device obtained by the process described above, and an organic EL device (element) formed with the same.

### BRIEF DESCRIPTION OF THE DRAWINGS

Figure 1 is a schematic view showing a technique of implanting or injecting an emission center-forming compound.

Figure 2 is a schematic sectional view showing one embodiment (single-layer structure) of the organic electroluminescence device of the present invention.

Figure 3 is a schematic sectional view showing another embodiment (multilayered structure) of the organic electroluminescence device of the present invention.

Figure 4 is a schematic sectional view showing still another embodiment (multilayered structure) of the organic electroluminescence device of the present invention.

Figure 5 is a schematic sectional view showing another embodiment (multilayer structure) of the organic electroluminescence device of the present invention.

Figure 6 is a schematic view showing another technique of implanting or injecting an emission center-forming compound.

### DETAILED DESCRIPTION OF THE INVENTION

### [Source (A)]

The source need only contain an emission center-forming compound absorptive of laser beams, and may be exclusively comprised of the emission center-forming compound, or of the emission center-forming compound and a binder.

### [Emission center-forming compound]

The emission center-forming compound need only be a compound which functions as an emission center-forming compound for organic EL device and is absorptive of laser beams. Particularly, compounds which emit light upon excitation by electrons and/or holes can be used. Examples are heterocyclic compounds containing at least one hetero atom selected from oxygen, nitrogen, and sulfur atoms [e.g., bis(C₁₋₆alkyl-benzoxazoyl)thiophene such as 2,5-bis(5-tert-butyl-2-benzoxazoyl)-thiophene; nile red; coumarins typified by coumarin 6 and coumarin 7; 4-(dicyanoC₁₋ ₄alkylene)-2-C₁₋₄alkyl-6-(p-diC₁₋₄alkylaminostyryl)-4H-pyran typified by 4-(dicyanomethylene)-2-methyl-6-(p-dimethylaminostyryl)-4H-pyran; and quinacridone]; condensed polycyclic hydrocarbons such as rubrene and perylene; tetraC₆₋₁₂aryl-1,3-butadiene such as 1,1,4,4-tetraphenyl-1,3-butadiene (TPB); bis(2-(4-C₁₋ ₄alkylphenyl)C₂₋₄alkynyl)benzene such as 1,4-bis(2-(4-ethylphenyl)ethynyl)benzene; and bis(2,2'-diC₆₋ ₁₂arylvinyl)biphenyl such as 4,4'-bis(2,2'-diphenylvinyl)biphenyl. Of these, nile red and coumarin 6 are preferable.

The structures of nile red and coumarin 6 are shown below:

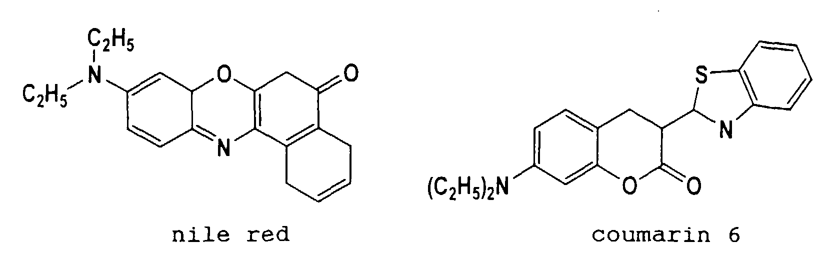

The wavelength of light emitted by nile red is 580 nm (emission of red light) and that of coumarin 6 is 490 nm (emission of green light).

These emission center-forming compounds may be used either singly or in combination. Incidentally, when forming the source only with the emission center-forming compound, an emission center-forming compound having film-forming properties is usually employed.

### [Binder]

As the binder, usually, a resin having film-forming properties (e.g., thermoplastic resin, thermosetting resin) can be used.

Examples of the thermoplastic resin are olefinic resins such as polyethylene, polypropylene, ethylenepropylene copolymer, and polybutene; styrenic resins such as polystyrene, rubber-modified polystyrene (HIPS), acrylonitrile-styrene copolymer, and acrylonitrile-butadiene-styrene copolymer; acrylic resins [e.g., homo-or copolymers of (meth)acrylic monomers (e.g., C₁₋₆alkyl (meth)acrylates such as methyl (meth)acrylate, ethyl (meth)acrylate, and butyl (meth)acrylate; hydroxyC₂₋ ₄alkyl (meth)acrylates such as hydroxyethyl (meth)acrylate and hydroxypropyl (meth)acrylate; glycidyl (meth)acrylate; (meth)acrylic acid; (meth)acrylonitrile); copolymers of the (meth)acrylic monomers mentioned above with copolymerizable monomers (e.g., aromatic vinyl monomers such as styrene) (e.g.,methyl methacrylate-styrene copolymer)]; vinyl-series resins such as vinyl alcohol-series polymers typified by polyvinyl alcohol and ethylene-vinyl alcohol copolymer, polyvinyl chloride, vinyl chloride-vinyl acetate copolymer, polyvinylidene chloride, polyvinyl acetate, ethylene-vinyl acetate copolymer, and polyvinylacetyl; polyamide-series resins such as 6-nylon, 6,6-nylon, 6,10-nylon, and 6,12-nylon; polyester resins [e.g., alkylene arylate-series resins such as polyalkylene terephthalates (e.g., polyethylene terephthalate, polybutylene terephthalate) and polyalkylene naphthalate, alkylene arylate copolyester resins]; fluorine-containing resins; polycarbonate; polyacetal; polyphenylene ether; polyphenylene sulfide; polyether sulfone; polyether ketone; thermoplastic polyimide; thermoplastic polyurethane; and norbornene-series polymers.

Exemplified as the thermosetting resin are phenolic resins, amino resins (e.g., urea resins and melamine resins), thermosetting acrylic resins, unsaturated polyester resins, alkyd resins, diallyl phthalate resins, epoxy resins, and silicone resins.

These binders can be used either singly or in combination.

When the source is constituted of an emission center-forming compound and a binder, the content of the emission center-forming compound is, relative to 100 parts by weight of the binder, about 0.1 to 30 parts by weight, preferably about 1 to 25 parts by weight, and more preferably about 3 to 20 parts by weight, albeit there is no particular restriction as to its content as long as it is possible to form a film. If possible, the content of the emission center-forming compound to the source may be 0.1 to 100%, preferably 10 to 95%, more preferably 30 to 90%.

The source (A) may be exclusively constituted of an emission center-forming compound having film-forming properties, or of the combination of an emission center-forming compound having or not having film forming-properties and the binder mentioned above. The source itself may be defined in a given pattern. For example, a film or sheet comprising an emission center-forming compound may be patterned by punching or other means to give a source. The source may be formed on the target. Moreover, a film (layer, deposit) defined in the predetermined pattern may be formed on a substrate (base material) to provide a source. The substrate need only be sufficiently transparent to transmit laser beams, examples of which are plates of soda glass, no-alkali glass, and quartz glass, and polymer sheets or films of polyester, polystyrene, acrylic resins, vinyl-series resins (e.g., polyvinyl acetal), polysulfone, and of polyethersulfone. If necessary, into the coating agent (coating liquid) for forming a coat (coating film), i.e., the source may incorporated a solvent (e.g., water; alcohols such as methanol and ethanol; esters such as ethyl acetate and isobutyl acetate; ketones such as acetone and methyl ethyl ketone; aromatic hydrocarbons such as toluene; alicyclic hydrocarbons such as cyclohexane; halogenated hydrocarbons such as chloroform and chlorobenzene; ethers; cellosolves; carbitols). The thickness of the coat may be about 0.1 to 50 µm, preferably about 0.5 to 30 µm, and more preferably about 1 to 20 µm, albeit there is no specific restriction as to the thickness. The predetermined pattern is provided on the substrate by, for example, printing such as screen printing, ink jet printing, melt or thermal transfer, or vapor deposition (sublimation printing) involving masking.

The pattern of the source is selected according to the intended application, and may be any of one-dimensional patterns [e.g., a dotted pattern, a lined pattern (e.g., parallel, random, grid)] and two-dimensional patterns [e.g., plane patterns (circular, oval, polygonal (triangle, rectangle, etc.)), star-shaped)]. The pattern may be constituted of a plurality of one-dimensional elemental patterns (dots, lines, etc.).

When the source is used without being defined in the predetermined pattern, the source may be constituted solely of the emission center-forming compound, or of the emission center-forming compound and the binder. However, the source is preferably constituted solely of the emission center-forming compound. For example, the emission center-forming compound content of the source may be 0.1 to 100%, preferably 10 to 95%, more preferably 30 to 90%. The source may be provided on the substrate or target in the form of a film comprising the above-described emission center-forming compound(s). As the substrate, those exemplified above can be employed. There is no particular restriction as to the process of forming such a source as described above, and a conventional process (e.g., dry processes such as vapor deposition (vacuum deposition), wet coating processes that use a solvent, such as spin coating, dip coating, die coating, and dripping coating) may be employed. In the case where the emission center-forming compound has film-forming properties or capability, the source may be formed in accordance with a conventional film-forming process (e.g., casting method).

The coating agent for forming the source film may incorporate any of the solvents listed above. Although there is no particular restriction as to the thickness of the resulting source, the thickness is for example 0.01 to 50 µm, preferably 0.05 to 30 µm, more preferably 0.1 to 20 µm.

### [Target (B)]

Insofar as the target is transmittable of laser beams and has at least one function selected from the electron-transporting and the hole-transporting function, there is no particular restriction in respect of the material forming the target, and the target may be (I) a resin having at least one function selected from the electron-transporting function and the hole-transporting function, or (II) a resin composition comprising a resin which inherently has neither the electron-transporting function nor the hole-transporting function but given with at least one function selected from these. As the resins (I) and (II), resins (organic polymers) having film- or coat-forming properties are preferred. Although there is no particular restriction as to in what form the target is in, usually, the target is used in the form of a film.

Exemplified as the resin (I) having at least one function selected from the electron-transporting and hole-transporting functions are polyphenylenevinylenes [e.g., homo- or copolymers of C₆₋₁₂aryleneviniylenes which may have a substituent (e.g., C₁₋₁₀alkoxy group), such as polyphenylenevinylene, poly(2,5-dimethoxyphenylenevinylene, and polynaphthalenevinylene]; polyphenylenes (in particular, polyparaphenylene) [e.g., homo- or copolymers of phenylenes which may have a substituent (e.g., C₁₋₁₀ alkoxy groups), such as polyparaphenylene and poly-2,5-dimethoxyparaphenylene]; polythiophenes [e.g., polyC₁₋₂₀alkylthiophenes such as poly(3-alkylthiophene); polyC₃₋₂₀cycloalkylthiophenes such as poly(3-cyclohexylthiophene); homo- or copolymers of C₆₋₂₀arylthiophenes which may have a substituent (e.g., C₁₋₁₀alkyl groups) such as poly(3-(4-n-hexylphenyl)thiophene)]; polyfluorenes such as polyC₁₋ ₂₀alkylfluorenes; vinyl-series polymers having at least one functional group selected from a hole-transporting functional group and an electron-transporting functional group in the main or side chain, such as poly-N-vinylcarbazole (PVK), poly-4-N,N-diphenylaminostyrene, poly(N-p-diphenylamino)phenylmethacrylamide), poly(N,N'-diphenyl-N,N'-bis(3-methylphenyl)-1,1'-biphenyl-4,4'-diaminomethacrylamide) (PTPDMA), and poly-4-(5-naphthyl-1,3,4-oxadiazole)styrene; polyC₁₋ ₄alkylphenylsilanes such as polymethylphenylsilane; polymers having an aromatic amine derivative in the side or main chain; and copolymers thereof. These resins can be used either singly or in combination. Preferred as the target are homo- or copolymers of which the main component [(e.g., 50% by weight or more, preferably 60 to 100% by weight) is N-vinylcarbazole (e.g., poly-N-vinylcarbazole, copolymers with a copolymerizable monomer such as (meth)acrylic monomers, styrenic monomers, and vinyl ester-series monomers)] and aromatic amine derivatives.

PVK is amorphous and excellent in heat resistance (glass transition temperature Tg: 224°C). The degree of polymerization of PVK is not particularly restricted, and is, for example, about 200 to 5,000 (e.g., 300 to 3,000), preferably about 500 to 2,000 (e.g., 500 to 1,500).

Further, if needed, the electron- or hole-transporting function is given to the resin (I).

Examples of the compound having an electron-transporting function are oxadiazole derivatives [e.g., oxadiazole derivatives having a C₆₋₁₂aryl group which may have a substituent, such as 2-(4-biphenyl)-5-(4-tert-butylphenyl)-1,3,4-oxadiazole (PBD), 2,5-bis(1-naphtyl)-1,3,4-oxadiazole (BND), 1,3-bis[5-(4-tert-butylphenyl)-1,3,4,-oxadiazole)]benzene (BPOB), 1,3,5-tris[5-4-tert-butylphenyl)-1,3,4-oxadiazole]benzene (TPOB), and 1,3,5-tris[5-(1-naphtyl)-1,3,4-oxadiazole]benzene (TNOB)]; diphenoquinones [e.g., diphenoquinones which may have a substituent (e.g., C₁₋ ₁₀ alkyl groups), such as 3,5,3',5'-tetrakis-tert-butyldiphenoquione]; 1,2,3,4,5-pentaphenyl-1,3-cyclopentadiene (PPCP); and quinolinic acid complexes such as tris(8-quinolinorato)aluminium (III) complex, bis(benzoquinolinorato)beryllium complex, and tris(10-hydroxybenzo[h]quinolilate)beryllium complex, with oxadiazole derivatives (e.g., PBD) particularly preferred.

As the compound having a hole-transporting function, there may be exemplified aromatic tertiary amines such as N,N'-diphenyl-N,N'-bis(3-methylphenyl)-1,1'-biphenyl-4,4'-diamine (TPD), N,N'-diphenyl-N,N'-bis(1-naphthyl)-1,1'-biphenyl-4,4'-diamine (NPD), 1,1-bis[(di-4-tolylamino)phenyl]cyclohexane, N,N,N'N'-tetra(3-methylphenyl)-1,3-diaminobenzene (PDA), 4,4',4"-tris(3-methylphenylphenylamino)triphenylamine (m-MTDATA), 4,4',4"-tris(1-naphthylphenylamino)triphenylamine(1-TNATA), 4,4',4"-tris(2-naphthylphenylamino)triphenylamine (2-TNATA), 4,4',4"-tri(N-carbazolyl)triphenylamine (TCTA), 1,3,5-tris[4-(3-methylphenylphenylamino)phenyl]benzene (m-MTDAPB), and triphenylamine; and phthalocyanines.

These compounds can be used either singly or in combination. Incidentally, of these compounds, those that are excited by electrons and/or holes and emit light may be used as emission center-forming compounds.

The proportion of the above-mentioned component contained in the resin (I) (e.g., PVK) can be selected within the range not adversely affecting the functions qualifying the resin as an organic EL material, and is, for example, about 10 to 300 parts by weight, preferably about 20 to 200 parts by weight relative to 100 parts by weight of the resin (I).

When the target is constituted of the resin (I) and the compound described above, the organic EL device which will later be described can be made so as to have a single-layered structure, and the organic EL device so fabricated not only has improved luminous efficiency but also is economically advantageous.

There is no specific restriction as to the resin composition (II), and such a variety of binders as exemplified in the section referring to the source (e.g., thermoplastic resins, thermosetting resins) are available. At least one function selected from the electron-transporting function and the hole-transporting function may be given to these resins. Exemplified as the compound(s) to be used to provide the resin composition (II) with the electron- or hole-transporting function are compounds similar to those listed above. Usually, use can be made of resins (organic polymers) having film- or coat-forming properties.

The amount of the compound having an electron-transporting or hole-transporting function to be added is about 10 to 300 parts by weight (e.g., 10 to 200 parts by weight) and preferably about 20 to 100 parts by weight (e.g., 20 to 80 parts by weight) relative to 100 parts by weight of the binder resin.

The resin (I) and the resin composition (II) may be used in combination, and such combined material may further be given at least one function selected from the electron-transporting function and the hole-transporting function.

### [Production process of organic EL material (molecular implantation)]

The process for producing organic EL materials of the present invention comprises the steps of bringing a source (A), containing at least an emission center-forming compound absorptive of laser beams and defined in the predetermined pattern, into contact with a target (B), implanting or injecting the emission center-forming compound contained in the source (A) into the target (B) by irradiating a laser beam from the source (A) or target (B) side thereby to provide an organic electroluminescence material having luminescence centers in the area corresponding to the pattern of the source (A). Usually, an organic EL device film is fabricated using a film as the target.

Incidentally, in the case where the source is constituted solely of the emission center-forming compound, the source may be used without being formed in the predetermined pattern.

Exemplified as the laser beam to be used in the present invention are, though it differs with the species of the emission center-forming compound to be used, those having an oscillation wavelength within the range of 190 to 1,100 nm. When using a pulse laser beam (pulsed laser beam), the frequency is about 0.5 to 50 Hz and preferably about 0.5 to 30 Hz. Moreover, although the pulse width varies with the wavelength of the laser beam, it is 10 ps to 10 us (e.g., 10 ps to 1 µs), preferably about 50 ps to 100 ns (e.g., 100 ps to 50 ns). The shorter the pulse width (duration) is, the less the decomposition of the emission center-forming compound occurs, and therefore, the emission center-forming compound is hardly damaged.

Exemplified as the source of the laser beam are gas laser [ArF excimer laser (193 nm), KrF excimer laser (248 nm), XeCl excimer laser (308 nm), XeF excimer laser (351 nm), nitrogen laser (337 nm)], dye laser [nitrogen laser, excimer laser, or YAG laser excitation, 300 to 1,000 nm], solid-state laser [Nd:YAG excitation, semiconductor laser excitation, etc., ruby laser (694 nm), semiconductor laser (650 to 980 nm), tunable diode laser (630 to 1,550 nm), titanium-sapphire laser (Nd:YAG excitation, 345 to 500 nm, 690 to 1,000 nm), and Nd:YAG laser (FHG: 266 nm, THG: 354 nm, SHG: 532 nm, fundamental wave: 1,064 nm)].

In the production process of the present invention, irradiation of a laser beam at such an intensity that the surface of the target (B) is not damaged is important. If the source (A) is to be constituted of an emission center-forming compound and a binder, irradiation of a laser beam at an intensity of or below the ablation threshold of the binder makes it possible to effectively implant the emission center-forming compound contained in the source film into the target. If the source (A) is to be exclusively constituted of an emission center-forming compound, the implantation can be done through irradiation of a laser beam at an intensity of or below the ablation threshold of the film of the emission center-forming compound. The amount of the emission center-forming compound to be implanted can be controlled by regulating, e.g., the intensity and wavelength of the laser beam, and how many times the laser beam is shot.

The ablation threshold of the source (A) varies with the species of the compound constituting the film, the binder resin, and of the emission center-forming compound. Moreover, the ablation threshold also depends on the wavelength and pulse width of the laser beam. In the present invention, the ablation threshold is defined as follows.

The term "ablation threshold value" used in the present invention is defined as a term referring to, assuming that a source is irradiated with one shot of a laser beam and observed by a contact-type surface morphology measuring apparatus (e.g., DEKTAK3030ST, manufactured by SLOAN), the lowest laser intensity (mJ/cm²) measured on the surface irradiated with the laser beam at which intensity the surface might suffer changes in surface conditions by a depth of 50 nm or more. The source and the laser beam are the same as those employed in the present invention.

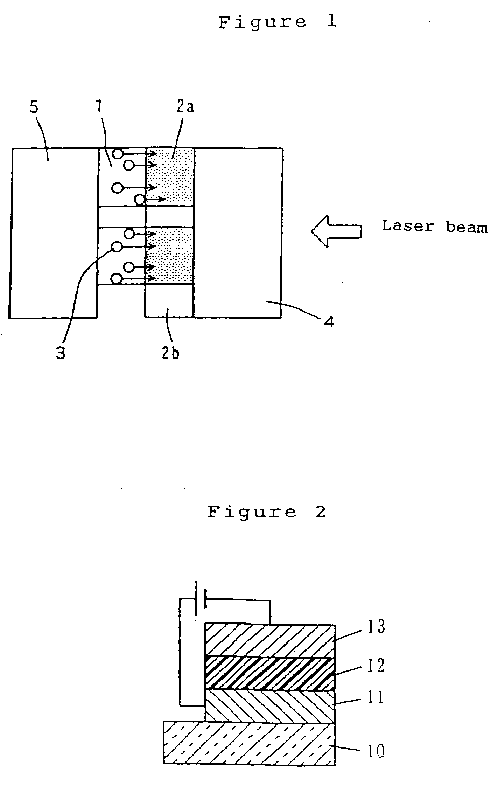

Hereinafter, the process of the present invention for producing a material for use in an organic EL device (particularly, films for use in organic EL devices) will be described with reference to Figures. Figure 1 shows one embodiment of the present invention. A source (1), target films (2a, 2b), an emission center-forming compound (3), a substrate (4) of the target film side, and a substrate (5) of the source side are illustrated therein. The pattern of the source can be made so as to correspond to the area into which the emission center-forming compound (3) is desired to be implanted (the desired emission pattern).

Firstly, the target films (2a, 2b) are interposed between the source (1) and the substrate (4) in such a manner as to be brought into contact with or intimate contact with the source (1), and irradiated with a laser beam from the target films (2a, 2b) side at an intensity of or below the ablation threshold of the source (1). Usually, the laser beam is shot about 1 to 50 times (preferably, about 1 to 25 times). Absorbing the laser beam, the emission center-forming compound in the source obtains high translational energy and is injected or implanted from the source into the target film (2a) without being decomposed, providing a film for organic EL device. The laser beam may be shot from the source side.

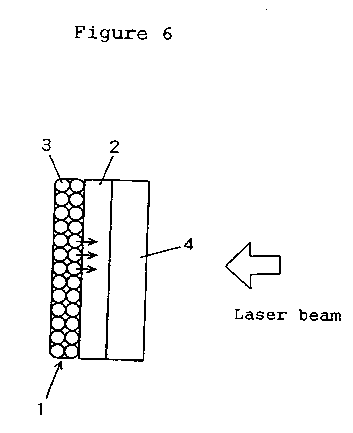

Figure 6 illustrates another embodiment of the present invention, showing a source (1), a target (2), an emission center-forming compound (3), and a substrate (4) of the target side. The source is constituted solely of the emission center-forming compound and not patterned.

Firstly, the source (1) is brought into contact or intimate contact with the target (2) formed on the substrate (4), and the source (1) is irradiated with a laser beam from the target (2) side at an intensity higher than the ablation threshold of the source (emission center-forming compound). In this process, the irradiation is repeated, for example, usually 1 to 200 times, preferably 1 to 150 times, more preferably 1 to 100 times (e.g., 5 to 100 times). The source, as a surface layer which is removable or separable, may be formed on the target directly. The laser beam may be shot from the source side.

The substrate to be used need only have sufficient transparency to transmit laser beams, examples of which are plates of glass such as soda glass, alkali-free glass and quartz glass, and polymer sheets or films of polyester, polystyrene, acrylic resins, vinyl-series resins (e.g., polyvinyl acetal), polysulfone, and of polyethersulfone. In the fabrication of flexible organic EL devices, polymer films are preferably employed.

In the process of producing organic EL materials of the present invention, there is no particular restriction as to the shape that the cross-section of the beam takes, and it may be circular, oval, or polygonal (e.g., triangle, rectangle). For an efficient implantation of the emission center-forming compound from the source to the target, it is preferred that the area of the cross-section of the laser beam is large. For example, the area of the cross-section of the beam is about 50 µm² to 20,000 mm² (e.g., 1,000 µm² to 15,000 mm²), preferably about 5,000 µm² to 10,000 mm², more preferably about 10,000 µm² to 5,000 mm². In the case where the source has the predetermined pattern, an area of the laser beam not smaller than a one-dimensional pattern or a two-dimensional pattern of the source (e.g., area of the cross-section of the beam: 5 x 10⁻² to 20,000 mm², preferably 1 to 10,000 mm²) makes it possible to implant, without scanning the laser beam or the target, the emission center-forming compound from the source to the target at a time.

Implantation of the emission center-forming compound from the source to the target requires suitable irradiation energy (irradiation energy of one pulse per unit area) and suitable number of laser pulses (in other words, the number of shots). Thus, once the irradiation energy is determined, the area of the cross-section of the beam is also determined according to the output of the laser to be used. Incidentally, the area of the cross-section of the beam is not limited within the above range and, if possible, from a manufactural viewpoint, the area may exceeds the above-mentioned range (e.g., 1 x 10⁴ to 1 x 10⁶ mm²).

Moreover, there may be used a plurality of sources having emission center-forming compounds different from one another. For example, emission of light of the desired color can be realized by using a compound capable of emitting light in the visible ray region (e.g., compounds capable of emitting yellow, red, green, or blue light). Multicolor patterning is made possible by employing a single source defined in the predetermined pattern and comprising a plurality of emission center-forming compounds capable of emitting different colors.

The emission center-forming compound may be injected into the desired area of the target by, with the beam diameter of the laser reduced to the desired size, scanning the pattern. Alternatively, the emission center-forming compound may be injected into the desired area of the target by irradiating the source with a laser beam through a photomask.

Particularly, by forming the source in the predetermined pattern in advance as in the former case, it is made possible to implant the emission center-forming compound without scanning with a laser beam. In addition, the need for the use of a photomask which might cause interference responsible for the beam is eliminated.

In the case where the source is constituted solely of the emission center-forming compound (e.g., the process of Figure 6), even if the number of times the source is irradiated with the beam and its energy are small, it is possible to implant the emission center-forming compound efficiently (energy efficiency) regardless of whether the source is a patterned one or a non-patterned one. Further, compared to the source comprised of a binder and an emission center-forming compound, the source not only allows the use of a pigment which is soluble in a solvent but enables the source to be used repeatedly, for some of the emission center-forming compound remains unimplanted even after the irradiation of laser beam. Therefore, the process (e.g., the process of Figure 6) is advantageous in terms of cost. Moreover, the formation of the source directly on the target followed by the irradiation of the source with the laser beam from the source side allows the emission center-forming compound to be directly irradiated with the laser beam, leading to a good energy efficiency.

According to the production process of the present invention, the emission center-forming compound can be injected into the target not in a dispersed or spread state but in a step-like state (i.e., the emission center-forming compound is injected into the target by a uniform depth, showing a rectangular profile). The depth varies with the species of the emission center-forming compound or the target, or with the laser intensity, and is for example about 10 nm to 300 nm, preferably about 15 nm to 200 nm, and more preferably about 20 nm to 100 nm. Furthermore, implantation of only the emission center-forming compound without deterioration of the surface smoothness of the resulting organic EL material is made possible, for the irradiation is effected at an intensity of or below the ablation threshold.

### [Organic electroluminescence device]

The organic electroluminescence device of the present invention comprises an organic EL material obtained by the process described above (particularly, a light-emitting layer constituted of a target film into which an emission center-forming compound has been implanted) and a pair of electrodes.

As the anode, a transparent electrode formed by vacuum deposition or other methods (e.g., indium-tin-oxide (ITO) electrode) or the like is employed, and a highly conductive metal having a small work function (e.g., magnesium, lithium, aluminum, or silver) is used as the cathode. In the case where magnesium is employed as the cathode, the magnesium may be coevaporated with a small amount of silver (e.g., 1 to 10% by weight) for improving the adhesion with an organic EL device-use film.

When the light-emitting layer has both the electron-transporting function and the hole-transporting function, the organic EL device of the present invention can be made so as to have a single-layered structure. When the light-emitting layer is lacking in either the electron-transporting function or the hole-transporting function or when attempting to improve each function, a layer having the desired function may be laminated on the light-emitting layer by a conventional vapor deposition technique or a solution coating technique. These layers may be of low-molecular weight compounds or macromolecular compounds, and either will do. The organic EL device can take, for example, a single-layer structure or a multilayer-structure as shown in Figures 2 to 5.

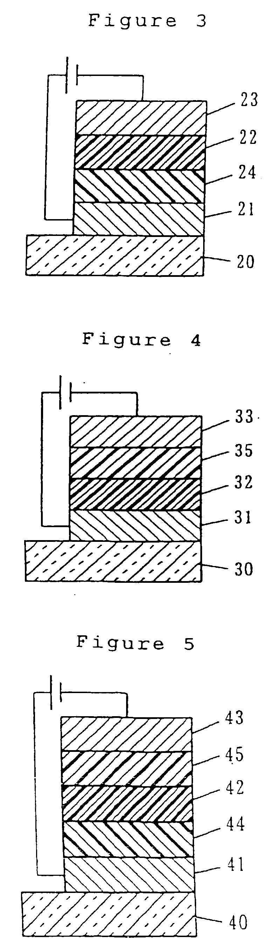

That is, as illustrated in Figure 2, the organic EL device may be one composed of a substrate (10), an anode (11) formed thereon, a light-emitting layer (12), and a cathode (13) laminated in this order, or, as shown in Figure 3, it may be one composed of a substrate (20), an anode (21) formed thereon, a hole-transporting layer (24), a light-emitting layer (22), and a cathode (23) laminated in this order. Further, as shown in Figure 4, the organic EL device may be one composed of a substrate (30), an anode (31) formed thereon, a light-emitting layer (32), an electron-transporting layer (35), and a cathode (33) laminated in this order, or, as shown in Figure 5, it may be one composed of a substrate (40), an anode (41) formed thereon, a hole-transporting layer (44), a light-emitting layer (42), an electron-transporting layer (45), and a cathode (43) laminated in this order.

The thickness of each of the layers constituting the organic EL device is not particularly limited, and is about 10 nm to 1 µm (e.g., 10 to 500 nm), preferably about 30 to 300 nm, more preferably about 30 to 200, particularly about 0.1 to 1 µm. When films are employed, the thickness of each film can be selected within the ranges mentioned above.

Exemplified as the substrate are those mentioned above, such as substrates having sufficient transparency to transmit laser beams (e.g., glass plates, such as those of soda glass, no-alkali glass, and quartz glass, polymer sheets or films of polyester, polysulfone, and polyethersulfone). For the fabrication of flexible organic EL devices, the use of polymer films are preferred.

According to the present invention, fine and multicolor patterning of an organic EL device made with macromolecular compounds which had long been difficult to realize was made possible. Further, since the organic EL material (particularly, organic EL device-use film) of the present invention is excellent in surface smoothness, it makes intimate contact with the electrodes, and the organic EL device of the present invention is free from the irregularity in voltage caused upon application of voltage because of the emission center-forming compound implanted therein step-like.

According to the present invention, even in the case where a macromolecular compound is employed as an organic EL material, a fine and minute multicolor patterning is made possible by molecular implantation employing a source defined in a given pattern. In the case where the source is constituted solely of the emission center-forming compound, minute patterning is possible even if the source is an unpatterned one. Moreover, since the irradiation of a laser beam is conducted at such an intensity so as not to damage the target or at an intensity of or below the ablation threshold of the source, it is possible to implant the emission center-forming compound uniformly without sacrificing the smoothness of the resulting organic EL material. Thus, the organic EL material of the present invention makes good contact with electrodes and makes uniform application of voltage possible.

### EXAMPLES

### Example 1

### (Preparation of source film)

A 10 µm-thick source film was fabricated by dissolving polybutyl methacrylate (Aldrich Chemical Company, Inc., molecular weight: 3.4 x 10⁵) containing 5% by weight of coumarin 6 (Nippon Kankoh Shikiso, K.K.) in chlorobenzene and then screen-printing a pattern (a rectangle of 1 mm x 1 mm) on a quartz substrate.

### (Preparation of Target Film)

500 mg of poly-N-vinylcarbazol having a hole-transporting function (PVK: manufactured by Kanto Kagaku, K.K.) and 500 mg of 2-(4-biphenyl)-5-(4-tert-butylphenyl)-1,3,4-oxadiazole having an electron-transporting function (PBD: Aldrich Chemical Company, Inc.) were dissolved in 10 ml of 1,2-dichloroethane. A coat layer of indium-tin-oxide (ITO) was formed on a glass substrate. Using the above-mentioned 1,2-dichloroethane solution, on the ITO coat layer thus obtained was formed a 100 nm-thick target film having the electron and hole-transporting functions by dip coating.

### (Molecular Implantation)

A test piece, composed of the source and the target film obtained above being in contact with each other, was fabricated, and, from the direction of the substrate adjoining the target film, the test piece was irradiated with XeF excimer laser (beam shape: rectangle of 3 mm x 5 mm, wavelength: 351 nm, pulse width: 10 ns, irradiation energy of one pulse per unit area: 20 mJ/cm²) ten times at a frequency of 1 Hz.

### (Organic EL device)

A 200 nm-thick Al/Li electrode (manufactured by Kohjundo Kagaku, K.K.; Li content: 0.78% by weight) was formed on the molecular-implanted target film by vacuum deposition to provide an organic EL device.

With the ITO electrode of the organic EL device as the anode and the Al/Li electrode layer as the cathode, a direct electric field was applied between the electrodes in the atmospheric air to cause the organic EL device to emit light. At a voltage of 18 V or so, emission of light was observed. Emission of green light due to coumarin 6 was observed at the area corresponding to the pattern of the source (rectangle of 1 mm x 1 mm) and that of blue light due to PVK at the area other than the area of green light emission.

### Example 2

### (Preparation of source)

A source was obtained in the same manner as in Example 1.

### (Preparation of target film)

On one hand 150 mg of N,N'-diphenyl-N,N'-bis(3-methylphenyl)-1,1'-biphenyl-4,4'-diamine having a hole-transporting function (TPD: Tokyo Kasei K.K.), 300 mg of 2-(4-biphenyl)-5-(4-tert-butylphenyl)-1,3,4-oxadiazole having an electron-transporting function (PBD: Aldrich Chemical Company, Inc.), and 450 mg of polymethyl methacrylate as a binder polymer having no carrier-transporting function (Aldrich Chemical Company, Inc.; PMMA) were dissolved in 30 mL of 1,2-dichloroethane, while on the other hand a coat of indium-tin-oxide (ITO) was formed on a glass substrate. Using the above-described 1,2-dichloroethane solution, on the ITO coat was formed a 100 nm-thick target film having the electron and hole-transporting functions by dip coating.

### (Molecular implantation)

A test piece, composed of the source and the target film obtained above being in contact with each other, was fabricated, and, from the direction of the substrate adjoining the target film, the test piece was irradiated with XeF excimer laser (beam shape: rectrangle of 3 mm x 5 mm, wavelength: 351 nm, pulth width: 10 ns, irradiation energy per unit area: 20 mJ/cm²) ten times at a frequency of 1 Hz.

### (Organic EL device)

A 200 nm-thick Al/Li electrode (manufactured by Kohjundo Kagaku, K.K.; Li content: 0.78% by weight) was formed on the molecular-implanted target film by vacuum deposition to provide an organic EL device.

With the ITO electrode of the organic EL device as the anode and the Al/Li electrode layer as the cathode, a direct electric field was applied between the electrodes in the atmospheric air to cause the organic EL device to emit light. At a voltage of 18 V or so, emission of light was observed. Emission of green light due to coumarin 6 was observed at the area corresponding to the pattern of the source (rectangle of 1 mm x 1 mm), and that of blue light due to TPD was observed at the area other than the area of green light emission.

### Example 3

### (Preparation of source film)

A source film was prepared by dissolving coumarin 6 (Nippon Kankoh Shikiso, K.K.) in methanol and applying the solution onto a quartz substrate using a spin coater.

### (Preparation of Target Film)

500 mg of poly-N-vinylcarbazol having a hole-transporting function (PVK: manufactured by Kanto Kagaku, K.K.) and 500 mg of 2-(4-biphenyl)-5-(4-tert-butylphenyl)-1,3,4-oxadiazole having an electron-transporting function (PBD: Aldrich Chemical Company, Inc.) were dissolved in 10 ml of 1,2-dichloroethane. A coat layer of indium-tin-oxide (ITO) was formed on a glass substrate. Using the above-mentioned 1,2-dichloroethane solution, on the ITO coat layer thus obtained was formed a 100 nm-thick target film having the electron and hole-transporting functions by dip coating.

### (Molecular Implantation)

A test piece, constituted of the source and the target films obtained above being in contact with each other, was fabricated, and, from the direction of the substrate adjoining the target film, the test piece was irradiated with third harmonic of YAG laser having a beam diameter of 1.8 mm (wavelength: 355 nm, pulse width: 3 ns, irradiation energy per unit area: 20 mJ/cm²) 100 times (test piece 1).

Except for that the irradiation energy per unit area and the number of times of irradiation were changed to 30 mJ/cm² and 5 times respectively, a test piece 2 was obtained in the same manner as in the fabrication of the test piece 1.

Moreover, exept for that the irradiation energy per unit area and the number of times of irradiation were changed to 30 mJ/cm² and 10 times respectively, a test piece 3 was obtained in the same manner as in the fabrication of the test piece 1.

### (Organic EL device)

A 200 nm-thick Al/Li electrode (manufactured by Kohjundo Kagaku, K.K.; Li content: 0.78% by weight) was formed on each of the molecular-implanted target films (test pieces 1 to 3) by vacuum deposition to provide organic EL devices 1 to 3.

With the ITO electrode of the organic EL device as the anode and the Al/Li electrode layer as the cathode, a direct electric field was applied between the electrodes in the atmospheric air to cause the organic EL device to emit light. At a voltage of 18 V or so, emission of light was observed for every organic EL device (1 to 3). Emission of green light due to coumarin 6 was observed at the area into which coumarin 6 had been injected, and that of blue light due to PVK at the area other than the area of green light emission.

## Claims

1. A process for producing an organic electroluminescence material comprises the steps of
bringing a source (A) containing at least an emission center-forming compound absorptive of a laser beam and formed in a predetermined pattern into contact with a target (B) which is transmittable of the laser beam and has at least one function selected from an electron-transporting function and a hole-transporting function, and
irradiating with the laser beam from the source (A) side or the target (B) side to implant the emission center-forming compound into an area of the target (B) corresponding to the pattern of the source (A).

2. A process according to claim 1, wherein the organic electroluminescence material is a material for use in an organic electroluminescence device.

3. A process according to claim 1, wherein the source (A) is a film formed on a substrate in a predetermined pattern.

4. A process according to claim 1, wherein the source (A) comprises an emission center-forming compound and a binder.

5. A process according to claim 4, wherein the irradiation of the laser beam is carried out at an intensity not higher than the ablation threshold of the source (A).

6. A process according to claim 1, wherein the organic electroluminescence material is a film.

7. A process according to claim 1, wherein the laser beam is a pulse laser beam.

8. A process according to claim 7, wherein the pulse width of the pulse laser beam is 10 ps to 10 µs.

9. A process according to claim 1, wherein the pattern may be a one-dimensional pattern or a two-dimensional pattern.

10. A process according to claim 1, wherein the target is an organic polymer having at least one function selected from the electron-transporting function and the hole-transporting function.

11. A process according to claim 11, wherein the organic polymer is a poly-N-vinylcarbazol or a copolymer comprising N-vinylcarbazol as a main component.

12. A process according to claim 1, wherein the target comprises a compound having at least one function selected from the electron-transporting function and the hole-transporting function, and an organic polymer having film-forming properties.

13. A process according to claim 12, wherein the compound is at least one compound selected from the group consisting of an oxadiazole derivative having the electron-transporting function and an aromatic tertiary amine having the hole-transporting function.

14. A process for producing an organic electroluminescence material having emission centers comprises bringing a source (A) constituted solely of an emission center-forming compound absorptive of a laser beam into contact with a target (B) having at least one function selected from an electron-transporting function and a hole-transporting function.

15. A process according to claim 14, wherein the source (A) is a film formed of the emission center-forming compound.

16. A process according to claim 14, wherein the source (A) is a film of the emission center-forming compound formed on a substrate.

17. A process according to claim 14, wherein the source (A) is a film of the emission center-forming compound formed on the target (B).

18. An organic electroluminescence material obtained by the process recited in claim 1 or 14

19. An organic electroluminescence material according to claim 18, wherein the target is an organic polymer having at least one function selected from the electron-transporting function and the hole-transporting function.

20. An organic electroluminescence device which comprises a pair of electrodes and an organic electrluminescence material recited in claim 20 which is interposed between the electrodes.

21. An organic electroluminescence device according to claim 20, wherein a single layer formed with an organic electroluminescence material recited in claim 19 is interposed between a pair of electrodes.
